# EUROPÄISCHE PATENTSCHRIFT

(11) **EP 3 305 872 B1**
(45) Veröffentlichungstag und Bekanntmachung des Hinweises auf die Patenterteilung: **23.10.2019**
(21) Anmeldenummer: 17202596.7
(22) Anmeldetag: 11.08.2010
(51) Int. Cl.: C09K 11/77, H01L 33/50

(54) **KONVERSIONS-LED MIT HOHER EFFIZIENZ**
HIGH EFFICIENCY CONVERSION LED
DEL À CONVERSION DE HAUTE EFFICACITÉ

(30) Priorität: 17.08.2009 DE 102009037732
(43) Veröffentlichungstag der Anmeldung: 11.04.2018
(62) Teilanmeldung aus: 10747437.1
(73) Patentinhaber: OSRAM Opto Semiconductors GmbH, 93055 Regensburg (DE)
(72) Erfinder: Baumann, Frank, 79540 Lörrach (DE); Windisch, Reiner, 93186 Pettendorf (DE); Lange, Stefan, 86157 Augsburg (DE); Fiedler, Tim, 86899 Landsberg am Lech (DE); Jermann, Frank, 86343 Königsbrunn (DE); Bönisch, Norbert, 86343 Königsbrunn (DE)
(74) Vertreter: Epping - Hermann - Fischer

(56) Entgegenhaltungen:
- EP-A2- 1 669 429
- US-B2- 6 649 946
- US-B2- 7 297 293
- U J L ET AL: "Cerium doped garnet phosphors for application in white GaN-based LEDs", LUMINESCENCE AND LUMINESCENT MATERIALS. SYMPO, MATERIALS RESEARCH SOCIETY, US, Bd. 667, 17. April 2001 (2001-04-17), Seiten G5.1.1-G5.1.6, XP008118036, ISBN: 978-1-55899-603-8
- WU J L ET AL: "SPECTRAL PROPERTIES OF VARIOUS CERIUM DOPED GARNET PHOSPHORS FOR APPLICATION IN WHITE GAN-BASED LEDS", MATERIALS RESEARCH SOCIETY SYMPOSIUM PROCEED; [MATERIALS RESEARCH SOCIETY SYMPOSIUM PROCEEDINGS], MATERIALS RESEARCH SOCIETY, PITTSBURG, PA; US, Bd. 658, 1. Januar 2001 (2001-01-01), Seiten GG11.8.1-GG11.8.6, XP009036120, ISBN: 978-1-55899-828-5

## Beschreibung

### Technisches Gebiet

Die Erfindung geht aus von einer Konversions-LED gemäß dem Oberbegriff des Anspruchs 1. Derartige Konversions-LEDs sind insbesondere für die Allgemeinbeleuchtung geeignet.

### Stand der Technik

Aus der US 6 649 946 ist eine Konversions-LED bekannt, die zur Erzielung einer weißen LED einen blauen Chip zusammen mit Sr₂Si₅N₈:Eu verwendet, wobei als zusätzlicher Leuchtstoff zur Verbesserung der Farbwiedergabe auch YAG:Ce verwendet wird. Damit lassen sich jedoch nur wenig effiziente LED realisieren.

Aus der US-B 7 297 293 ist eine Konversions-LED bekannt, die zur Erzielung einer weißen LED einen blauen Chip zusammen mit (Sr,Ca)₂Si₅N₈:Eu verwendet, wobei als zusätzlicher Leuchtstoff zur Verbesserung der Farbwiedergabe auch YAG:Ce sowie ähnliche Leuchtstoffe mit teilweisem Ersatz des Y durch Gd bzw. teilweisem Ersatz des Al durch Ga verwendet wird. Damit lassen sich jedoch nur wenig effiziente LED realisieren.

Aus der EP-A 1 669 429 ist eine Konversions-LED bekannt, die zur Erzielung einer weißen LED einen blauen Chip zusammen mit speziellem Leuchtstoff des Typs (Sr,Ba)₂Si₅N₈:Eu verwendet, wobei als zusätzlicher Leuchtstoff zur Verbesserung der Farbwiedergabe auch LuAG:Ce sowie ähnliche Leuchtstoffe, die mit Ce und Pr kodotiert sind, verwendet werden.

Auch die Druckschriften J. L. Wu et al. "Cerium doped garnet phosphors for application in white GaN-based LEDs", Luminescence and Luminescence Materials, Symp., Materials Research Society, US, Bd 667, 17. April 2001, Seiten G5.1.1.-G5.1.6 und J. L. Wu et al. "Spectral Properties of various cerium doped garnet phosphors for application in white GaN-based LEDs", Materials Research Society Symposium Proceed, Materials Research Society, US, Bd. 658, 1. Januar 2001, Seiten GG11.8.1-GG11.8.6 offenbaren Leuchtstoffe für Leuchtdiodenanwendungen.

### Darstellung der Erfindung

Die Aufgabe der vorliegenden Erfindung ist es, eine Konversions-LED bereitzustellen, die mit hoher Effizienz ausgestattet ist, wobei die Konversions-LED insbesondere eine hohe nutzbare Lebensdauer erreicht.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt eine Konversions-LED hoher Effizienz bereitgestellt. Nicht alle Leuchtstoffe sind bei hohen Strömen, hier insbesondere mindestens 250 mA, bevorzugt mindestens 300 mA, besonders bevorzugt mindestens 350 mA, betriebenen LEDs, sog. Hochleistungs-LED, stabil. Insbesondere gilt diese Problematik für nitridische oder oxinitridische Leuchtstoffe wie das Nitridosilikat M₂Si₅N₈:Eu. Viele derartige Leuchtstoffe, insbesondere Nitride des Typs M₂Si₅N₈:D mit D als Aktivator erleiden beim Betrieb in einer LED deutliche Konversionsverluste. Beim Belastungstest mit bis zu 700 mA Dauerstrom verlieren weiße LEDs mit derartigen Leuchtstoffen in kurzer Zeit (typisch 1000 Std.) bis zu 50% Konversionseffizienz. Dies führt zu einer ausgeprägten Instabilität des Farborts.

Weiße LEDs gewinnen in der Allgemeinbeleuchtung immer mehr an Bedeutung. Insbesondere steigt die Nachfrage nach warmweißen LEDs mit niedrigen Farbtemperaturen, bevorzugt im Bereich 2900 bis 3500 K, insbesondere 2900 bis 3100 K, und guter Farbwiedergabe, insbesondere Ra ist mindestens 93, bevorzugt mindestens 96, und gleichzeitig hoher Effizienz. Erreicht werden diese Ziele in der Regel durch die Kombination einer blauen LED mit gelben und roten Leuchtstoffen. Die Spektren all dieser Lösungen weisen eine Region im blau-grünen Spektralbereich auf, in der sehr wenig Strahlung emittiert wird (Blau-Grün-Lücke), dadurch ergibt sich eine mangelhafte Farbwiedergabe. Zur Kompensation werden in der Regel sehr langwellige blaue LEDs eingesetzt (ca. 460nm). Seitens der Chiptechnologie ist es jedoch vorteilhaft, LEDs kürzerer Chipwellenlängen einzusetzen, da diese deutlich effizienter sind. Gewünscht sind Wellenlängen (Peak) von 430 bis 455 nm, insbesondere 435 bis 445 nm.

Wird der blau-grüne Anteil des Gesamtspektrums im Wesentlichen alleine durch die blaue LED bestimmt, wie dies bei den bisherigen Kombinationen aus langwelliger blauer LED und gelbem sowie rotem Leuchtstoff der Fall ist, so ergibt sich eine starke Abhängigkeit des Gesamt-CRI der weißen LED von der eingesetzten Chipwellenlänge. Aus technischen Gründen muss jedoch in der Praxis immer ein relativ breiter Bereich von Chipwellenlängen in einem Produkt verwendet werden, so dass große Schwankungen im CRI die Folge sind. Weiterhin müssen die Leuchtstoffe eine sehr hohe Stabilität gegenüber chemischen Einflüssen, beispielsweise Sauerstoff, Feuchtigkeit, Wechselwirkungen mit Vergussmaterialien, sowie gegenüber Strahlung aufweisen. Um einen stabilen Farbort bei steigender Systemtemperatur zu gewährleisten, sind außerdem Leuchtstoffe erforderlich, die ein sehr geringes Temperaturlöschverhalten aufweisen.

Die bisherigen effizientesten Warmweiß-Lösungen basieren auf der Kombination eines gelben Granatleuchtstoffs wie YAG:Ce oder YAGaG:Ce, der Al und Ga gleichzeitig enthält, und einem Nitridosilikat wie (Ba,Sr,Ca)₂Si₅N₈:Eu. Um eine hinreichend gute Farbwiedergabe zu erreichen, ist hier der Einsatz sehr langwelliger blauer LEDs (etwa 455 bis 465 nm) nötig, wodurch aber die Systemeffizienz deutlich eingeschränkt wird. Bei Verwendung kürzerer Chipwellenlängen von 430 bis 450 nm, vorteilhaft bis 445 nm, mit den bisherigen Leuchtstoffen ist aber die Farbwiedergabe mangelhaft, insbesondere im blau-grünen Spektralbereich. Weiterhin ergeben sich durch die starke Abhängigkeit des CRI von der Blau-Wellenlänge signifikante Schwankungen des CRI innerhalb des Produkts. Die Stabilität der bisherigen Lösung in der LED ist gerade noch ausreichend. Bei hohen Strömen, hier insbesondere mindestens 250 mA, bevorzugt mindestens 300 mA, besonders bevorzugt mindestens 350 mA, ist sie kritisch, da die thermische Belastung immer mehr steigt.

Die neue Lösung besteht aus der Kombination aus einem grün bis grün-gelb emittierenden Granatleuchtstoff und einem kurzwelligen, schmalbandigen orange-rot emittierenden Nitridosilikat-Leuchtstoff. Der grüne Granatleuchtstoff zeigt gegenüber den bisher eingesetzten gelben (YAG) bzw. grüngelben (YAGaG) Granaten eine stark grünverschobene Emission, gleichzeitig ist das Anregungsoptimum stark kurzwellig verschoben. Diese Grünverschiebung des Granats führt zu einer deutlichen Verkleinerung der Blau-Grün-Lücke im Weißspektrum.

Aufgrund dieser Eigenschaften können deutlich kurzwelligere LEDs (ca. 435 nm bis 445 nm Peakwellenlänge statt 455 nm in der bisherigen Lösung) eingesetzt werden und gleichzeitig weiterhin ein CRI der weißen LED von größer 80 erreicht werden. Durch die speziellen spektralen Eigenschaften der neu entwickelten Leuchtstoff-Mischung bleibt zudem der CRI über einen weiten Bereich blauer LED-Wellenlängen annähernd konstant, wodurch eine gleichmäßige Farbqualität innerhalb eines "LED-Bins" gewährleistet wird. Weiterhin zeichnet sich die neu entwickelte Kombination dieser Leuchtstoffe durch eine sehr hohe chemische und photochemische Stabilität sowie eine sehr geringes Temperaturlöschverhalten aus.

Der entscheidende Fortschritt besteht jetzt darin, dass eine gleichzeitige Verbesserung mehrerer aus Applikationssicht zentraler Eigenschaften erreicht wurde, nämlich in Bezug auf Alterungsstabilität, Effizienz, verwendbarer Chipwellenlängenbereich und Temperaturstabilität der Leuchtstoffe. Der Unterschied dieser neuen Lösung gegenüber vorbekannten Warmweiß-Lösungen mit niedrigen Farbtemperaturen, bevorzugt im Bereich 2900 bis 3500 K, insbesondere 2900 bis 3100 K ist:
- Sehr stark grünverschobener Granatleuchtstoff. Dies bringt Vorteile bei: CRI, Augenbewertung, Temperaturstabilität; λ_{dom} sollte bevorzugt bei 552-559 nm liegen, die FWHM sollte bevorzugt bei 105- 113 nm liegen (bezogen auf Anregung bei 435 nm) .
- Sehr kurze Chipwellenlänge von 430 bis 450 nm PeakWellenlänge. Dies bringt einen großen Vorteil im Hinblick auf hohe Effizienz.
- Kurzwellig emittierender und schmalbandiger Rotleuchtstoff; λ_{dom} sollte bevorzugt bei 596-604 nm liegen, die FWHM sollte bevorzugt kleiner 100nm, besonders bevorzugt kleiner 90 nm liegen (bezogen auf Anregung bei 435 nm). Dies bringt Vorteile bei: Lebensdauer der LED, Augenbewertung.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: einen Vergleich der Temperaturabhängigkeit verschiedener grün emittierender Leuchtstoffe;
- Fig. 3: einen Vergleich der Temperaturabhängigkeit verschiedener rot emittierender Leuchtstoffe;
- Fig. 4: einen Vergleich des Effizienzverlusts von Nitridosilikaten für verschiedene Dotiergehalte an Eu als Funktion des Ba-Anteils;
- Fig. 5: einen Vergleich des Effizienzverlusts von Nitridosilikaten unter verschiedenem Belastungsszenario als Funktion des Ba-Anteils;
- Figur 6: einen Vergleich des Konverterverlusts vor und nach Belastung für verschiedene Leuchtstoffe;
- Figur 7: einen Vergleich der Zeitabhängigkeit der Konverter-Verluste für verschiedene Leuchtstoffe;
- Fig. 8: einen Vergleich des CRI für verschiedene Leuchtstoffmischungen bei Wellenlängenverschiebung der Primäranregung;
- Fig. 9: einen Vergleich der Gesamtemission einer Konversions-LED bei verschiedener Primäremission;
- Fig. 10-12: einen Vergleich der Emission von LuAGaG bzw. YAGaG bzw. Misch-Sion bei verschiedener Peaklage der Primäremission (Ex);
- Fig. 13: ein LED-Modul mit entfernt angebrachter Leuchtstoffmischung;
- Fig. 14: einen Vergleich der Emission bei Lu-Granaten, die verschiedenen Gehalt an Y enthalten.

### Bevorzugte Ausführungsform der Erfindung

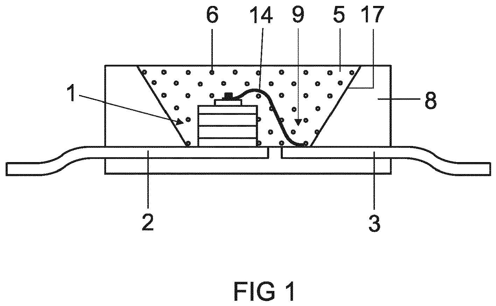

Figur 1 zeigt den Aufbau einer Konversions-LED für weißes Licht auf RGB-Basis wie an sich bekannt. Die Lichtquelle ist ein Halbleiterbauelement mit einem blau emittierenden Chip 1 des Typs InGaN in Hochstromausführung mit 350 mA Betriebsstrom. Er hat eine Peakemissionswellenlänge von 430 bis 450 nm Peakwellenlänge, beispielsweise 435 nm, und ist in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (70 bis 95 Gew.-%) und Leuchtstoffpigmente 6 (weniger als 30 Gew.-%) enthält. Ein erster Leuchtstoff ist ein grün emittierendes LuAGaG:Ce, ein zweiter Leuchtstoff ist ein rot emittierendes Nitridosilikat SrBaSi₅N₈:Eu. Die Ausnehmung hat eine Wand 17, die als Reflektor für die Primär- und Sekundärstrahlung vom Chip 1 bzw. den Pigmenten 6 dient.

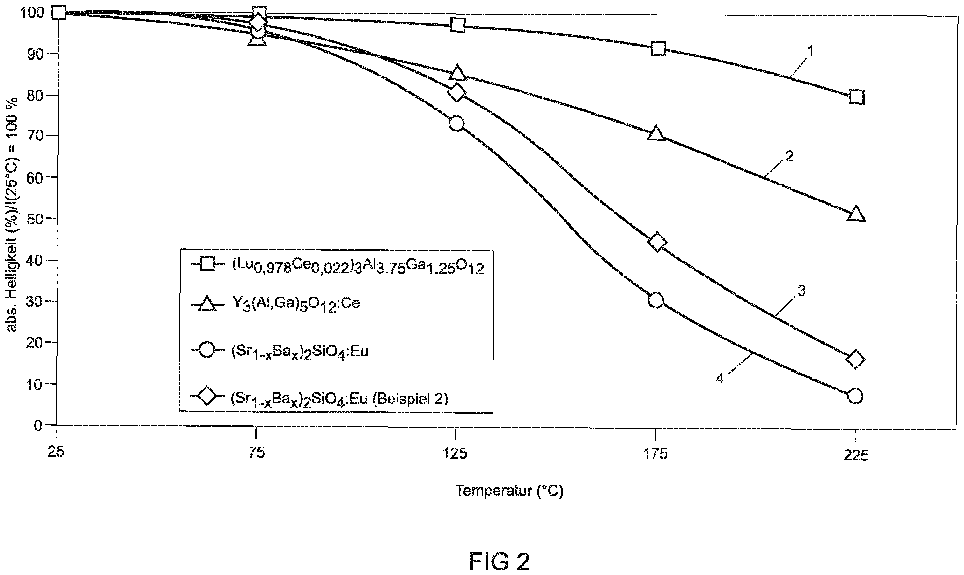

Figur 2 zeigt das Temperaturlöschungs-Verhalten verschiedener gelb-grün emittierender Leuchtstoff, die sich im Prinzip gut mit dem Chip aus Figur 1 anregen lassen. Der Leuchtstoff A₃B₅O₁₂:Ce, wobei A=überwiegend Lu, in der Ausführungsform mit der bevorzugten Zusammensetzung LuAGaG, also Lu₃(Al,Ga)₅O₁₂:Ce mit ca. 25% Anteil Ga für Komponente B (bevorzugt sind 10-40% Ga-Anteil, besonders bevorzugt sind 15-30% Ga-Anteil) und ca. 2,2% Ce (bevorzugt sind 1.5-2.9% Ce, besonders bevorzugt 1.8-2.6% Ce, jeweils bezogen auf den Anteil A), zeichnet sich durch sehr geringe Temperaturlöschung aus. Ein bevorzugter Leuchtstoff ist (Lu_{0.978}Ce_{0.022})₃Al_{3.75}Ga_{1.25}O₁₂, siehe Kurve 1. Die Grafik zeigt einen Vergleich mit anderen gelben und grünen Leuchtstoffen, die ein wesentlich schlechteres Temperaturlöschungs-Verhalten zeigen. Orthosilikate (Kurve 3,4) sind völlig ungeeignet, aber auch YAGaG (Kurve 2) ist unbrauchbar.

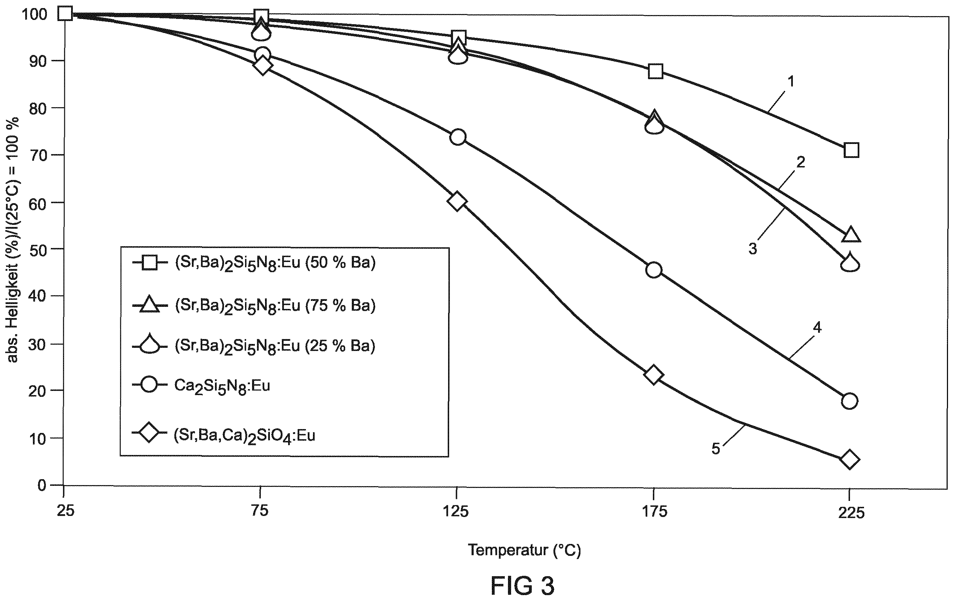

Figur 3 zeigt das Temperaturlöschungs-Verhalten verschiedener orange-rot emittierender Leuchtstoff, die sich im Prinzip gut mit dem Chip aus Figur 1 anregen lassen. Der neue Leuchtstoff vom Typ Nitridosilikat M₂Si₅N₈:Eu mit der bevorzugten Zusammensetzung (Sr,Ba)₂Si₅N₈:Eu mit ca. 50% Ba ((x = 0.5); allgemein ist bevorzugt x = 0.35-0.75, besonders bevorzugt x = 0.4-0.6) und ca. 4% Eu ((y =0.04); allgemein ist bevorzugt ein Eu-Anteil an M von x = 0.01-0.20, besonders bevorzugt x = 0.02-0.06), zeichnet sich durch sehr geringe Temperaturlöschung aus. Gut geeignet ist ein Nitridosilikat mit x = 0.4-0.6 vom Typ Sr_{1-x-y/2}Ba_{x-y/2}Eu_{y})₂Si₅N₈, siehe Kurve 1. Die Grafik zeigt einen Vergleich mit anderen orange/roten Leuchtstoffen. Deutlich schlechter geeignet sind Nitridosilikate mit x= 0,25 oder x=0,75, siehe Kurve 2 und 3. Ungeeignet sind Ca-Nitridosilikate (Kurve 4) und Orthosilikate (Kurve 5).

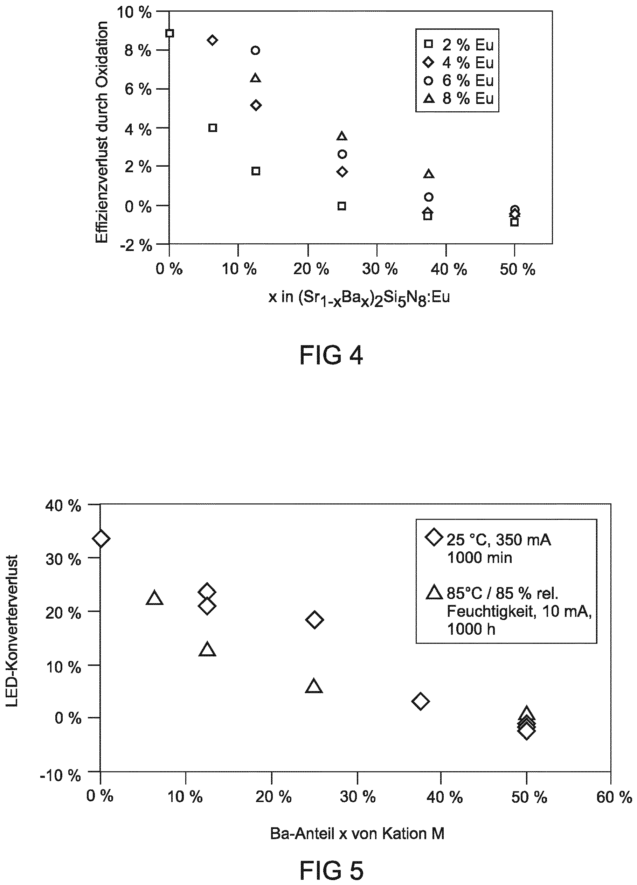

Figur 4 zeigt das Ergebnis eines Oxidations-Stabilitätstests. Dabei wurde die Stabilität des Systems (Sr,Ba)₂Si₅N₈:Eu mit variablem Ba-Gehalt ermittelt. Dazu wurde die Probe zunächst charakterisiert, anschließend 68h bei 150°C an Luft ausgeheizt und anschließend nochmals charakterisiert. Die Differenz beider Effizienzen zu unterschiedlichen Zeitpunkten gibt den Effizienzverlust an. Die besten Leuchtstoffe sind im Rahmen der Messfehler perfekt stabil. Bevorzugt ist dabei der Leuchtstoff mit ca. 45 bis 53% Ba bei ca. 4% Eu-Anteil von M, insbesondere der Leuchtstoff (Sr_{0,48}Ba_{0.48}Eu_{0,04})₂Si₅N₈.

Figur 5 zeigt das Ergebnis eines LED-Alterungstests. Dabei wurde die Stabilität des Systems (Sr,Ba)₂Si₅N₈:Eu mit variablem Ba-Gehalt x ermittelt. Dabei wurde eine blaue Hochleistungs-LED (λₚₑₐₖ bei etwa 435 nm) mit einer Dispersion des jeweiligen Leuchtstoffs in Silikon vergossen und diese bei 350 mA für 1000 min betrieben. Die relativen Intensitäten des blauen LED-Peaks der Primäremission sowie des Leuchtstoffpeaks wurden zum Beginn und zum Ende des Tests gemessen und daraus der Verlust der Konversionseffizienz relativ zur Intensität des blauen LED-Peaks bestimmt. Man erkennt in Figur 5 (viereckige Messpunkte) eine eindeutige Zunahme der Stabilität mit steigendem Barium-Gehalt. Der als optimal sich erweisende Leuchtstoff mit ca. 50% Ba und ca. 4% Eu ((Sr_{0,48}Ba_{0.48}Eu_{0,04})₂Si₅N₈, L358) ist im Rahmen der Messfehler perfekt stabil. In einem weiteren Test (1000h, 10mA, 85% rel. Luftfeuchtigkeit, 85°C) zeigt sich die gleiche Tendenz (dreieckige Messpunkte).

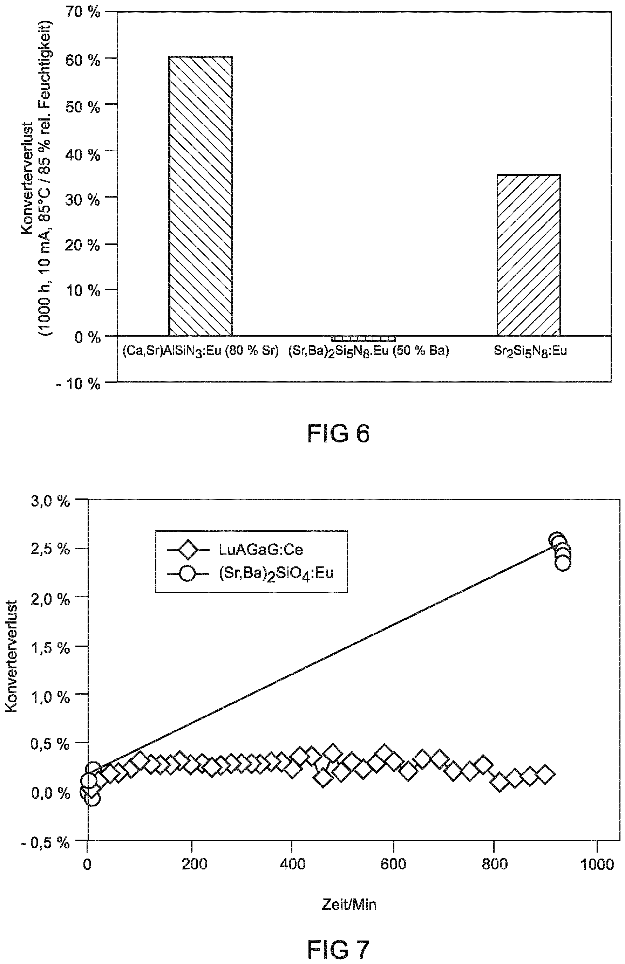

Figur 6 zeigt den Vergleich dreier Rot-Leuchtstoff-Systeme mit schmalbandiger Emission mit λ_{dom} < 605 nm in einem LED-Alterungstest (1000h, 10mA, 85% rel. Luftfeuchtigkeit, 85°C): die erste Säule bezieht sich auf ein Calsin mit Sr-Anteil, die zweite Säule ist der erfindungsgemäß beste Leuchtstoff, ein gemischtes Nitridosilikat mit gleichen Anteilen Sr und Ba, die dritte Säule zeigt das Verhalten des reinen Sr-Nitridosilikats. Das gemischte Nitridosilikat ist im Rahmen der Messfehler perfekt stabil, während die Vergleichssysteme sehr stark altern.

Figur 7 zeigt die Stabilität der gelb-grün-Komponente. In einem LED-Alterungstest wurde die Stabilität des neuen Grünleuchtstoffs mit der bevorzugten Zusammensetzung (LuAGaG mit ca. 25% Ga und ca. 2,2% Ce, (Lu_{0.978}Ce_{0.022})₃Al_{3.75}Ga_{1.25}O₁₂) ermittelt und mit anderen bekannten gelb/grünen Leuchtstoffen verglichen. Dabei wurde eine blaue Hochleistungs-LED (λₚₑₐₖ=435 nm) mit einer Dispersion des jeweiligen Leuchtstoffs in Silikon vergossen und diese bei 350 mA für 1000 h betrieben. Die relativen Intensitäten des blauen LED-Peaks sowie des Leuchtstoffpeaks wurden zum Beginn und zum Ende gemessen und daraus der Verlust der Konversionseffizienz bestimmt. Der neue LuAGaG-Leuchtstoff ist im Rahmen der Messfehler perfekt stabil (viereckige Messpunkte) während ein Orthosilikat unter vergleichbaren Bedingungen deutliche Alterungserscheinungen zeigt (runde Messpunkte).

Die Farbwiedergabe der warmweißen LED mit der erfindungsgemäßen neuen Leuchtstoffmischung gelb-grün mit orange-rot ist praktisch unabhängig von der eingesetzten LED-Wellenlänge. Eine Verschiebung der Blau-Wellenlänge um 9 nm bewirkt nur einen CRI-Verlust von 1 Punkt. Das Gegenbeispiel der bisherigen Mischung verliert bereits bei einem Unterschied von 7 nm Blau-Wellenlänge 5 Punkte (siehe Tabelle 1). Um den CRI-Verlust auf 1 Punkt zu verringern, ist die Zugabe eines dritten Leuchtstoffs nötig, was die Effizienz und das Colour-Steering negativ beeinflusst.

**Tab. 1: hier bedeutet CRI den Farbwiedergabeindex**

| Muster | Peak-Wellenlänge der blauen LED / nm | Farbtemperatur /K | Leuchtstoff 1 (grün-gelb) | Leuchtstoff 2 (orange-rot) | Leuchtstoff 3 (blau-grün) | Verhältnis gelb:rot | CRI Ra8 |
|---|---|---|---|---|---|---|---|
| 1 | 444 | 3000 | LuAGaG:2.2 %Ce (25%Ga) | (Sr,Ba)2Si5N8:Eu (50% Ba) | - | 9.3:1 | 83 |
| 2 | 435 | 3050 | LuAGaG:2.2 %Ce (25%Ga) | (Sr,Ba)2Si5N8:Eu (50% Ba) | - | 8.9:1 | 82 |
| | | | | | | | |
| VGL1 | 462 | 3200 | YAG:3%Ce | (Sr,Ca)2Si5N8:Eu (60% Sr) | - | 9:1 | 81 |
| VGL2 | 455 | 3250 | YAG:3%Ce | (Sr,Ca)2Si5N8:Eu (60% Sr) | - | 10.3:1 | 76 |
| VGL3 | 455 | 3200 | YAG:3%Ce | (Sr,Ca)2Si5N8:Eu (60% Sr) | grünes Chlorosilikat | 9:1 | 80 |
| | | | | | | | |
| VGL4 | 462 | 3250 | YAGaG:4%Ce (25%Ga) | (Sr,Ca)2Si5N8:Eu (60% Sr) | - | 6.1:1 | 86 |
| VGL5 | 455 | 3250 | YAGaG:4%Ce (25%Ga) | (Sr,Ca)2Si5N8:Eu (60% Sr) | - | 7:1 | 83 |
| VGL6 | 444 | 3200 | YAGaG:4%Ce (25%Ga) | (Sr,Ca)2Si5N8:Eu (60% Sr) | - | 7:1 | 77 |

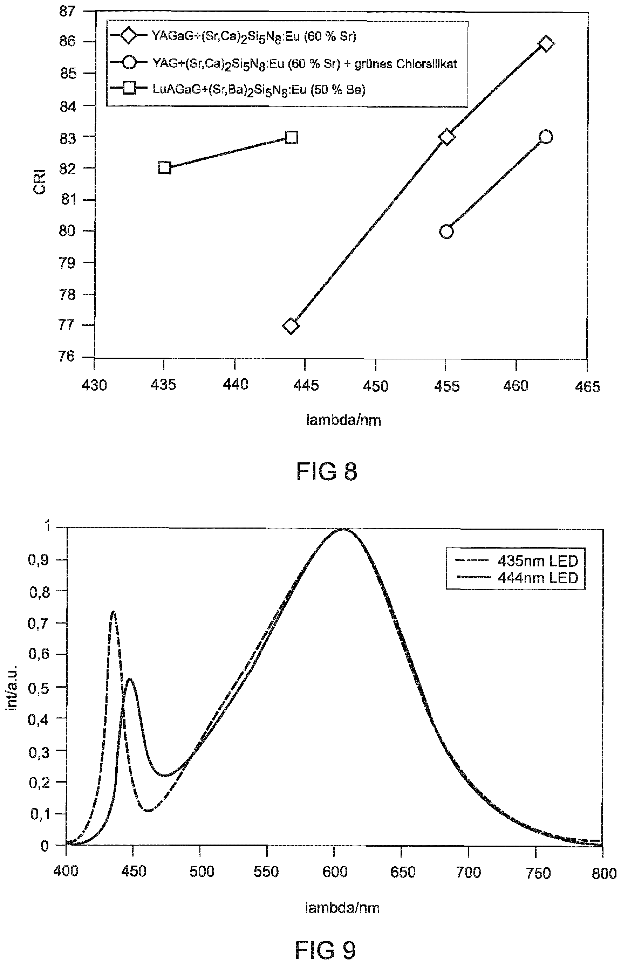

Figur 8 zeigt den Farbwiedergabeindex (CRI) Ra8 für verschiedene Systeme. Die Farbwiedergabe einer warmweißen LED mit der erfindungsgemäßen neuen Leuchtstoffmischung (Muster 1 und 2) ist praktisch unabhängig von der eingesetzten LED-Wellenlänge. Eine Verschiebung der Blau-Wellenlänge um 9 nm bewirkt nur einen CRI-Verlust von 1 Punkt (viereckige Messpunkte). Das Vergleichsbeispiel der bisherigen Mischung verliert bereits bei einem Unterschied von 7 nm Blau-Wellenlänge 5 Punkte (runde Messpunkte; siehe Tabelle, VGL 1 und VGL3). Um den CRI-Verlust auf 1 Punkt zu verringern, ist die Zugabe eines dritten Leuchtstoffs nötig (VGL2), was die Effizienz und das Colour-Steering negativ beeinflusst. Ein weiteres Vergleichsbeispiel (rautenförmige Messpunkte) bezieht sich auf YAG als gelb-grüner Komponente mit Sr-Ba-Nitridosilikat. Erstaunlicherweise ist dieses System drastisch schlechter als das verwandte erfindungsgemäße System und ähnlich schlecht wie die Drei-Leuchtstoff-Variante (VGL2).

Figur 9 erläutert die Ursache für die (nahezu perfekte) Unabhängigkeit des Farbwiedergabeindex CRI von der Blau-Wellenlänge: Die Leuchtstoff-Emission verschiebt sich beim erfindungsgemäßen System überraschend mit zunehmend kurzwelliger Anregungswellenlänge deutlich zu kurzen Wellenlängen hin. Dadurch ergibt sich eine gewisse Kompensation im Gesamtspektrum: Die fehlenden Blau-Grün-Anteile durch Einsatz einer kürzerwelligen LED werden durch die verstärkten Blau-Grün-Anteile der verschobenen Leuchtstoffemission gerade in etwa ausgeglichen.

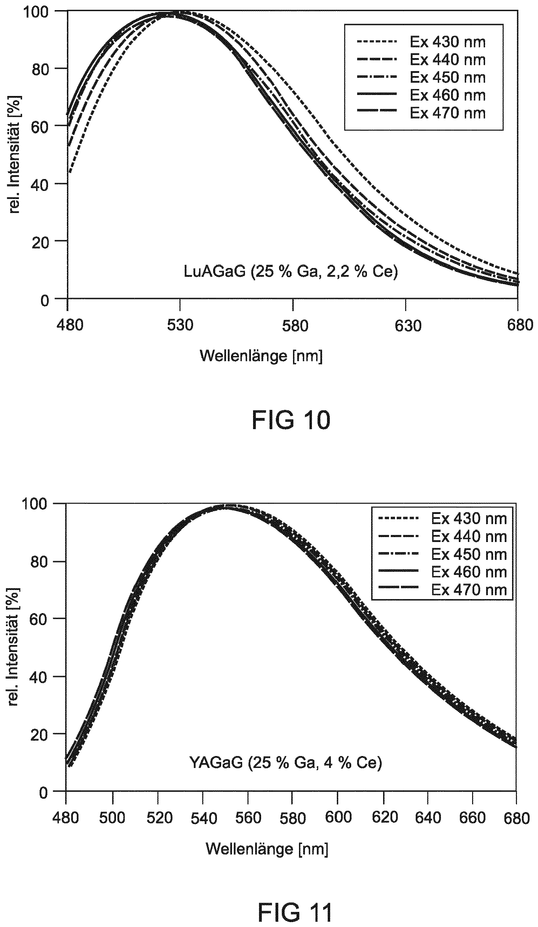

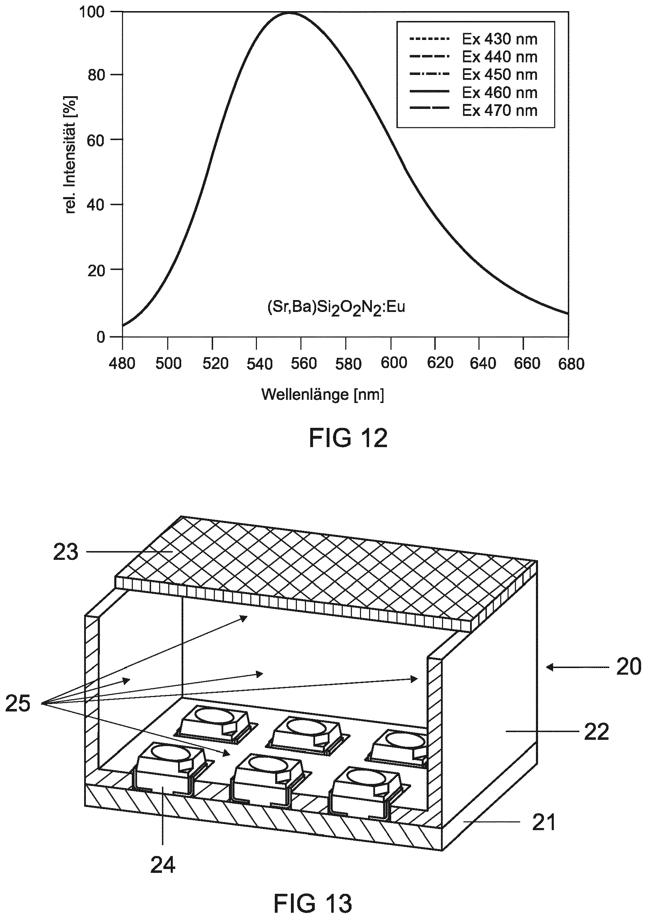

Figur 10 zeigt die relative Intensität bei einer Verschiebung des Leuchtstoffspektrums des Grün-gelb-Leuchtstoffs mit variabler Anregungswellenlänge zwischen 430 und 470 nm (Ex430 bis 470) im Vergleich zu YAGaG:Ce (Figur 11) und gelbem (Sr,Ba)Si₂O₂N₂:Eu (Figur 12).

Überraschenderweise verhält sich der neue grüne LuAGaG-Granat deutlich anders als die Vergleichs-Leuchtstoffe. Er zeigt eine starke Grünverschiebung mit sinkender Anregungswellenlänge. Die Vergleichs-Leuchtstoffe bleiben etwa konstant. Gezeigt sind die Emissionsspektren der drei Leuchtstoffe im Vergleich im für LED-Anwendungen interessanten Blauwellenlängenbereich zwischen 430 und 470nm. Die Kurven der Figur 12 liegen praktisch alle übereinander, so dass nur eine Kurve dargestellt ist.

Der Einsatz eines Lutetium-Granats, der allenfalls Y als Beimischung bis 30 Mol.-% enthält, wirkt sich - bedingt durch die geänderte Form des Emissionsspektrums - insgesamt deutlich positiv auf die Farbwiedergabe aus. Der Einsatz von Y-Granaten führt nicht zu derart hohen Werten der Farbwiedergabe, die mit Lu-Granat realisierbar sind. Details verschiedener Mischungen finden sich in Tab. 2. Gd ist als wesentliche Komponente völlig ungeeignet und sollte, ebenso wie Tb oder La, höchstens zur Feinabstimmung in kleinen Mengen bis 5 Mol.-% der Komponente A zugesetzt werden. Dagegen liefert ein Anteil Y bis etwa 30%, bevorzugt mit einem Anteil 10 bis 25%, eine gute Ergänzung zu Lu. Ursache ist der relativ ähnliche Ionenradius von Lu und Y. Höhere Werte von Y würden die Emission des Leuchtstoffs aber wieder in einen Bereich verschieben, der die gewünschte Performance des Gesamtsystems beeinträchtigen würde. Im Vergleich mit Yttrium-Granaten mit ähnlicher Leuchtstoff-Emissionswellenlänge (Muster VGL 1 bis VGL4), und überraschend sogar bei ähnlicher dominanter Leuchtstoff-Emissionswellenlänge (Muster VGL 3 und VGL4), ergeben sich bei den Mustern 1 bis 3 deutlich höhere Farbwiedergabewerte Ra8, siehe Tabelle 2. ergeben sich bei den Mustern 1 bis 3 deutlich höhere Farbwiedergabewerte Ra8, siehe Tabelle 2. Dadurch und durch die gute Anregbarkeit bei kurzen Wellenlängen können erstmals hocheffiziente, kurzwellige blaue LEDs für Konversions-LED eingesetzt werden.

**Tab. 2**

| Muster | Peak- Wellenlänge der blauen LED / nm | Farbtemperatur /K | Leuchtstoff 1 (grün-gelb) | Leuchtstoff 2 (orange-rot) | Verhältnis gelb:rot | Ra8 |
|---|---|---|---|---|---|---|
| VGL1 | 455 | 3150 | YAG:2%Ce | Sr2Si5N8:Eu | 16:1 | 77 |
| VGL2 | 455 | 3200 | YAGaG:4%Ce (25%Ga) | Sr2Si5N8:Eu | 7:1 | 79 |
| 1 | 455 | 3200 | LuAG:4%Ce | Sr2Si5N8:Eu | 7.8:1 | 82 |
| | | | | | | |
| | | | | | | |
| VGL3 | 444 | 3000 | YAGaG:2%Ce (40%Ga) | (Sr,Ba)2Si5N8:Eu (87.5% Sr) | 10.6:1 | 85 |
| 2 | 444 | 3050 | LuAGaG:2.2%Ce (25%Ga) | (Sr,Ba)2Si5N8:Eu (87.5% Sr) | 12.4:1 | 89 |
| | | | | | | |
| | | | | | | |
| VGL4 | 435 | 3100 | YAGaG:2%Ce (40%Ga) | (Sr,Ba)2Si5N8:Eu (50% Ba) | 7:1 | 78 |
| 3 | 435 | 3100 | LuAGaG:2.2%Ce (25%Ga) | (Sr,Ba)2Si5N8:Eu (50% Ba) | 7:1 | 82 |

Grundsätzlich ist die Verwendung der Leuchtstoff-Mischung als Dispersion, als Dünnfilm etc. direkt auf der LED oder auch wie an sich bekannt, auf einem separaten, der LED vorgeschalteten Träger möglich. Figur 13 zeigt ein derartiges Modul 20 mit diversen LEDs 24 auf einer Grundplatte 21. Darüber ist ein Gehäuse montiert mit Seitenwänden 22 und einer Deckplatte 12. die Leuchtstoff-Mischung ist hier als Schicht 25 sowohl auf den Seitenwänden als auch vor allem auf der Deckplatte 23, die transparent ist, angebracht.

Die Bezeichnung Leuchtstoff des Typs Nitridosilikat M₂Si₅N₈:Eu beinhaltet auch Modifikationen des einfachen Nitridosilikats, bei dem Si teilweise durch Al und/oder B ausgetauscht sein kann und wobei N teilweise durch O und/oder C ausgetauscht sein kann, so dass durch den Austausch Ladungsneutralität gewährleistet ist. Derartige modifizierte Nitridosilikate sind an sich bekannt, siehe dazu beispielsweise EP-A 2 058 382. Formal kann ein derartiges Nitridosilikat als M₂X₅Y₈:D beschrieben werden, mit M=(Ba,Sr) und X=(Si,A,B) und Y=(N,O,C) sowie D=Eu allein oder mit einer Kodotierung.

Tab. 3 zeigt verschiedene Granate aus dem System A₃B₅O₁₂:Ce mit A ausgewählt aus (Lu,Y). Dabei zeigt sich, dass für A=Lu bis hin zu A= 70%Lu, Rest Y gute Werte erzielt werden können. Gleichzeitig muss für Komponenten B das Verhältnis zwischen Al und Ga sorgfältig gewählt werden. Der Anteil Ga sollte zwischen 10 und 40 Mol.-%, insbesondere 10 bis 25% liegen. Dabei sind in Tab. 7 verschiedene (Lu,Y)-Granate A₃B₅O₁₂:Ce gezeigt, wobei die Konzentration des Aktivators Ce jeweils 2% von A beträgt und A = Lu,Y (angegeben ist der Anteil des Lu, Rest ist Y) sowie B= Al,Ga (angegeben ist der Anteil Ga, Rest ist Al) gewählt ist. Reiner LuAG:Ce oder YAG:Ce ist ungeeignet. Ebenso ist die Zugabe von Pr für die Effizienz des Leuchtstoffs äußerst schädlich und sollte tunlichst vermeiden werden.

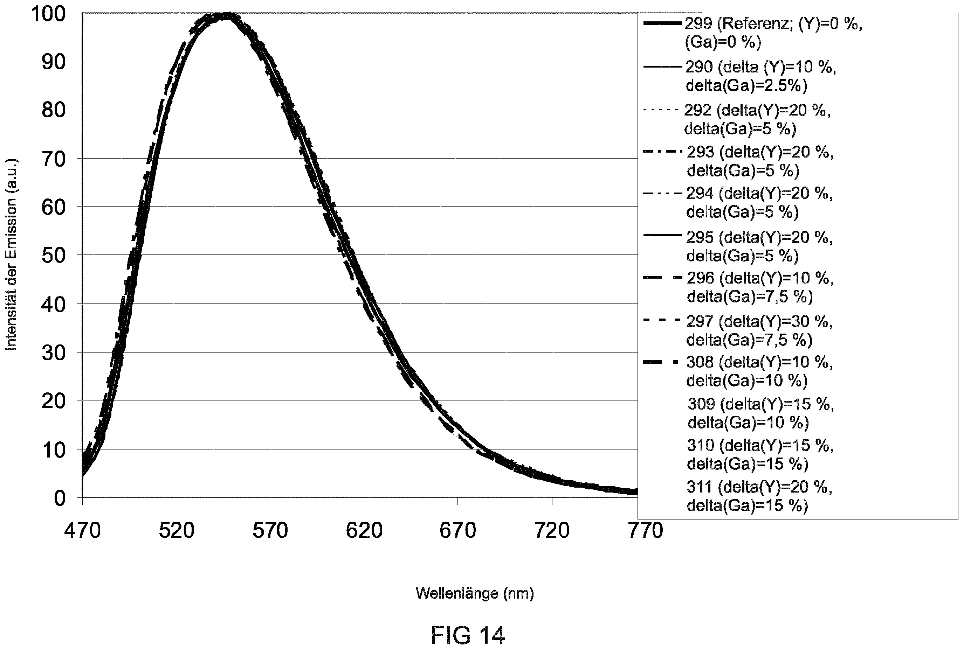

Figur 14 zeigt Emissionsspektren für verschiedene Granate, bei denen der Anteil des Y variiert wurde. Es zeigt sich, dass die Emission für kleine Anteil Y nahezu konstant bleibt.

Tab. 4 zeigt reine LuAGAG-Leuchtstoffe mit schrittweise erhöhtem Ga-Anteil. Diese Tabellenwerte, auch der anderen Tabellen, beziehen sich grundsätzlich immer auf eine Referenzanregung bei 460 nm.

**Tab. 4: Lu(Al,Ga)-Granate A₃B₅O₁₂:Ce (sog. LuAGAG)**

| Probennummer | Anteil Lu, Rest Y | Anteil Ga, Rest Al | x | y | lambda_dom / nm | FWHM / nm | rel. QE |
|---|---|---|---|---|---|---|---|
| **SL 315c/08** | **100%** | **5,0%** | **0,350** | **0,567** | **557,5** | **109,1** | **1,00** |
| **SL 005c/09** | **100%** | **15,0%** | **0,337** | **0,572** | **555,1** | **104,3** | **1,01** |
| **SL 003c/09** | **100%** | **20,0%** | **0,351** | **0,564** | **557,7** | **108,4** | **1,05** |
| **SL 167c/08** | **100%** | **25,0%** | **0,352** | **0,562** | **557,9** | **109,8** | **1,05** |

**Tab. 3: (Lu, Y) -Granate A₃B₅O₁₂:Ce**

| Probennummer | Anteil Lu, Rest Y | Anteil Ga, Rest Al | x | y | lambda_dom / nm | FWHM / nm | rel. QE |
|---|---|---|---|---|---|---|---|
| SL 299c/08 | 1 00% | 0,0% | 0,393 | 0,557 | 564,2 | 112,5 | 1,00 |
| SL 290c/08 | 88% | 2,5% | 0,396 | 0,556 | 564,6 | 113,2 | 1,02 |
| SL 291c/08 | 68% | 2,5% | 0,414 | 0,550 | 567,1 | 115,4 | 1,01 |
| SL 292c/08 | 78% | 5,0% | 0,400 | 0,555 | 565,2 | 113,7 | 1,01 |
| SL 293c/08 | 78% | 5,0% | 0,400 | 0,556 | 565,1 | 114,3 | 1,01 |
| SL 294c/08 | 78% | 5,0% | 0,401 | 0,555 | 565,3 | 114,8 | 1,02 |
| SL 295c/08 | 78% | 5,0% | 0,401 | 0,555 | 565,3 | 113,8 | 1,02 |
| SL 296c/08 | 88% | 7,5% | 0,388 | 0,559 | 563,5 | 112,8 | 1,02 |
| SL 297c/08 | 68% | 7,5% | 0,402 | 0,555 | 565,4 | 114,4 | 1,03 |
| SL 308c/08 | 88% | 10,0% | 0,383 | 0,560 | 562,8 | 112,1 | 1,03 |
| SL 309c/08 | 83% | 10,0% | 0,387 | 0,559 | 563,3 | 112,5 | 1,03 |
| SL 310c/08 | 83% | 15,0% | 0,381 | 0,560 | 562,5 | 113,0 | 1,03 |
| SL 311c/08 | 78% | 15,0% | 0,385 | 0,559 | 563,1 | 112,3 | 1,02 |

## Patentansprüche

1. Konversions-LED mit einem Chip, der primäre blaue Strahlung emittiert, sowie einer dem Chip vorgelagerten Leuchtstoff enthaltenden Schicht, die mindestens einen Teil der primären Strahlung des Chips in sekundäre Strahlung konvertiert, wobei ein erster gelb-grün emittierender Leuchtstoff des Typs Granat A₃B₅O₁₂:Ce und ein zweiter orange-rot emittierender Leuchtstoff des Typs Nitridosilikat M₂X₅Y₈:D verwendet wird, **dadurch gekennzeichnet, dass** die PeakWellenlänge der primären Strahlung im Bereich 430 bis 450 nm, insbesondere bis 445 nm, liegt, während der erste Leuchtstoff ein Granat mit dem Kation A = Lu oder eine Mischung Lu,Y mit bis zu 30% Y-Anteil ist, und wobei der erste Leuchtstoff bei der Komponente B 10% bis 40 Mol.-% Ga, enthält, Rest ist Al, während der zweite Leuchtstoff ein Nitridosilikat ist, das gleichzeitig Ba und Sr als Kation M enthält, und bei dem die Dotierung aus Eu besteht, wobei der zweite Leuchtstoff 35 bis 75 Mol.-% Ba bei der Komponente M enthält, Rest ist Sr, wobei X=Si und Y=N gilt.

2. Konversions-LED nach Anspruch 1, **dadurch gekennzeichnet, dass** der erste Leuchtstoff bei der Komponente B 15 bis 40 Mol.-% Ga enthält.

3. Konversions-LED nach einem der vorhergehenden Ansprüche, **dadurch gekennzeichnet, dass** der erste Leuchtstoff bei der Komponente B 15 bis 35 Mol.-% Ga enthält.

4. Konversions-LED nach einem der vorhergehenden Ansprüche, **dadurch gekennzeichnet, dass** der erste Leuchtstoff bei der Komponente B 20 bis 30 Mol.-% Ga enthält.

5. Konversions-LED nach Anspruch 1, wobei der erste Leuchtstoff bei der Komponente B 10 bis 35 Mol.-% Ga enthält.

6. Konversions-LED nach Anspruch 1, **dadurch gekennzeichnet, dass** der erste Leuchtstoff 1,5 % bis 2,9 Mol.-% Ce, insbesondere 1,8 bis 2,6 Mol.-% Ce, bei der Komponente A enthält, Rest ist A, insbesondere nur Lu oder Lu mit einem Anteil Y von bis zu 25 %.

7. Konversions-LED nach einem der vorhergehenden Ansprüche, **dadurch gekennzeichnet, dass** der zweite Leuchtstoff 40 bis 60 Mol.-% Ba enthält.

8. Konversions-LED nach einem der vorhergehenden Ansprüche, **dadurch gekennzeichnet, dass** der zweite Leuchtstoff 1 bis 20 Mol.-% Eu bei der Komponente M enthält, Rest ist (Ba,Sr).

9. Konversions-LED nach einem der vorhergehenden Ansprüche, **dadurch gekennzeichnet, dass** der zweite Leuchtstoff 2 bis 6 Mol.-% Eu bei der Komponente M enthält, Rest ist (Ba,Sr).

10. Konversions-LED nach Anspruch 1, **dadurch gekennzeichnet, dass** der zweite Leuchtstoff (Sr_{0,48}Ba_{0,48}Eu_{0,04})₂Si₅N₈ ist.

11. Konversions-LED nach Anspruch 10, **dadurch gekennzeichnet, dass** der erste Leuchtstoff A₃B₅O₁₂ ist, mit A = 75 bis 100% Lu, Rest Y und einem Ce-Gehalt von 1,5 bis 2,5%, mit B = 10 bis 40 % Ga, Rest Al.

12. Konversions-LED nach Anspruch 11, **dadurch gekennzeichnet, dass** der erste Leuchtstoff A₃B₅O₁₂ ist, mit A = 80 bis 100% Lu, Rest Y und einem Ce-Gehalt von 1,5 bis 2,5%, mit B = 15 bis 30 % Ga, Rest Al.

13. Konversions-LED nach Anspruch 12, **dadurch gekennzeichnet, dass** der erste Leuchtstoff (Lu_{0.978}Ce_{0.022})₃Al_{3.75}Ga_{1.25}O₁₂ ist.

## Claims

1. A conversion LED with a chip, which emits primary blue radiation, as well as a phosphor containing layer, which converts at least a part of the primary radiation of the chip into secondary radiation, upstream of the chip, wherein a first yellow-green emitting phosphor of the type garnet A₃B₅O₁₂:Ce and a second orange-red emitting phosphor of the type nitride silicate M₂X₅Y₈:D is used, **characterized in that**
the peak wavelength of the primary radiation is in the range of 430 to 450 nm, in particular to 445 nm, while the first phosphor is a garnet with the cation A = Lu or a mixture of Lu, Y with a 30% fraction of Y up to, and wherein the first phosphor comprises 10% to 40 mol% Ga at the component B, remainder Al, while the second phosphor is a nitride silicate, which contains both Ba and Sr as cation M, and in which the doping consists of Eu, wherein the second phosphor contains 35 to 75 mol% Ba for the component M, remainder is Sr, wherein X = Si and Y = N is valid.

2. Conversion LED of claim 1, **characterized in that** the first phosphor contains in component B 15 to 40 mol% Ga.

3. Conversion LED according to any of the preceding claims, **characterized in that** the first phosphor contains in component B 15 to 35 mol% Ga.

4. Conversion LED according to any of the preceding claims, **characterized in that** the first phosphor contains in component B 20 to 30 mol% Ga.

5. Conversion LED of claim 1, **characterized in that** the first phosphor contains in component B 10 to 35 mol% Ga.

6. Conversion LED of claim 1, **characterized in that** the first phosphor contains 1.5% to 2.9 mol% Ce, in particular 1.8 to 2.6 mol% Ce, in the component A, remainder is A, in particular only Lu or Lu with a fraction Y up to 25%.

7. Conversion LED according to any of the preceding claims, **characterized in that** the second phosphor contains 40 to 60 mol% Ba.

8. Conversion LED according to any of the preceding claims, **characterized in that** the second phosphor contains in component M 1 to 20 mol% Eu, remainder is (Ba,Sr).

9. Conversion LED according to any of the preceding claims, **characterized in that** the second phosphor contains in component M 2 to 6 mol% Eu, remainder is (Ba,Sr).

10. Conversion LED according to claim 1, **characterized in that** the second phosphor is (Sr_{0.45}Ba_{0.45}Eu_{0.04})₂Si₅N₈.

11. Conversion LED according to claim 10, **characterized in that** the first phosphor is A₃B₅O₁₂ with A = 75 to 100% Lu, remainder Y and a Ce content of 1.5 to 2.5%, with B = 10 to 40% Ga, remainder Al.

12. Conversion LED according to claim 11, **characterized in that** the first phosphor is A₃B₅O₁₂ with A = 80 to 100% Lu, remainder Y and a Ce content of 1.5 to 2.5%, with B = 15 to 30% Ga, remainder Al.

13. Conversion LED according to claim 12, **characterized in that** the first phosphor is (Lu_{0.978}Ce_{0.022})₃Al_{3.75}Ga_{1.25}O₁₂.

## Revendications

1. LED de conversion avec une puce électronique, qui émet un rayonnement bleu primaire, ainsi qu'une couche contenant une substance luminescente en amont de la puce électronique, qui convertit au moins une partie du rayonnement primaire de la puce électronique en rayonnement secondaire, sachant qu'une première substance luminescente émettrice de jaune-vert du type grenat A₃B₅O₁₂:Ce est utilisée et une seconde substance luminescente émettrice d'orange-rouge du type nitridosilicate M₂X₅Y₈:D, **caractérisée en ce que** la longueur d'ondes de pic du rayonnement primaire se trouve dans la zone de 430 à 450 nm, notamment jusqu'à 445 nm, pendant que la première substance luminescente est un grenat avec le cation A = Lu ou un mélange de Lu, Y avec jusqu'à 30 % de proportion d'Y, et sachant que la première substance luminescente contient pour le composant B 10 % à 40 % mol. de Ga, **en ce que** le reste est de l'Al, pendant que la seconde substance luminescente est un nitridosilicate, qui contient simultanément du Ba et du Sr comme cation M, et pour laquelle le dopage se compose d'Eu, sachant que la seconde substance luminescente contient 35 à 75 % mol. de Ba pour le composant M, que le reste est du Sr, sachant que X=Si et Y=N.

2. LED de conversion selon la revendication 1, **caractérisée en ce que** la première substance luminescente pour le composant B contient 15 à 40 % mol. de Ga.

3. LED de conversion selon une quelconque des revendications précédentes, **caractérisée en ce que** la première substance luminescente pour le composant B contient 15 à 35 % mol. de Ga.

4. LED de conversion selon une quelconque des revendications précédentes, **caractérisée en ce que** la première substance luminescente pour le composant B contient 20 à 30 % mol. de Ga.

5. LED de conversion selon la revendication 1, **caractérisée en ce que** la première substance luminescente pour le composant B contient 10 à 35 % mol. de Ga.

6. LED de conversion selon la revendication 1, **caractérisée en ce que** la première substance luminescente pour le composant B contient 1,5 % à 2,9 % mol. de Ce, notamment 1,8 à 2,6 % mol. de Ce, pour le composant A, **en ce que** le reste est A, notamment seulement du Lu ou du Lu avec une proportion Y de jusqu'à 25 %.

7. LED de conversion selon une quelconque des revendications précédentes, **caractérisée en ce que** la seconde substance luminescente contient 40 à 60 % mol. de Ba.

8. LED de conversion selon une quelconque des revendications précédentes, **caractérisée en ce que** la seconde substance luminescente contient 1 à 20 % mol. d'Eu pour le composant M, **en ce que** le reste est du (Ba, Sr).

9. LED de conversion selon une quelconque des revendications précédentes, **caractérisée en ce que** la seconde substance luminescente contient 2 à 6 % mol. d'Eu pour le composant M, **en ce que** le reste est du (Ba, Sr).

10. LED de conversion selon la revendication 1, **caractérisée en ce que** la seconde substance luminescente est du (Sr_{0,48}Ba_{0,48}Eu_{0,04})₂Si₅N₈.

11. LED de conversion selon la revendication 10, **caractérisée en ce que** la première substance luminescente est du A₃B₅O₁₂, avec A = 75 à 100 % de Lu, le reste du Y et un taux de Ce de 1,5 à 2,5 %, avec B = 10 à 40 % de Ga, le reste de l'Al.

12. LED de conversion selon la revendication 11, **caractérisée en ce que** la première substance luminescente est du A₃B₅O₁₂, avec A = 80 à 100 % de Lu, le reste du Y et un taux de Ce de 1,5 à 2,5 %, avec B = 15 à 30 % de Ga, le reste de l'Al.

13. LED de conversion selon la revendication 12, **caractérisée en ce que** la première substance luminescente est du (Lu_{0,978}Ce_{0,022})₃Al_{3,75}Ga_{1,25}O₁₂.
